# FASCICULE DE BREVET EUROPEEN

(11) **EP 0 421 834 B1**
(45) Date de publication et mention de la délivrance du brevet: **07.12.1994**
(21) Numéro de dépôt: 90402489.0
(22) Date de dépôt: 11.09.1990
(51) Int. Cl.: C23C 16/48, C23C 16/30, C23C 16/52

(54) **Procédé pour la réalisation d'un dépot d'un revêtement protecteur inorganique et amorphe sur un substrat polymérique organique**
Verfahren zur Auftragung einer amorphen anorganischen Schutzschicht auf ein polymeres organisches Substrat
Process for depositing an amorphous, inorganic, protective coating on an organic polymer substrate

(30) Priorité: 14.09.1989 FR 8912063
(43) Date de publication de la demande: 10.04.1991
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Friedt, Jean-Marie, Room 104, Shinjuku-ku, Tokyo F 162 (JP); Claverie, Pierre, Tschiura-shi, Ibaraki Pref. F 300 (JP); Perrin, Jérôme, F-75013 Paris (FR)
(74) Mandataire: Vesin, Jacques

(56) Documents cités:
- US-A- 4 615 294
- US-A- 4 654 226
- 4EME COLLOGUE INTERNATIONAL SUR LES PLASMAS ET LA PULVERISATION CATHODIQUE, Nice, 13-17 septembre 1982, pages 95-98, Société Française du Vide; B. DREVILLON et al.: "Application de l'ellipsometrie spectroscopique rapide à l'etude de la formation de couches minces de silicium amorphe"
- JAPANESE JOURNAL OF APPLIED PHYSCIS, vol. 24, no. 3, partie 1, mars 1985, pages 274-278, Tokyo, JP; J. TAKAHASHI et al.: "UV irradiation effects on chemical vapor deposition of SiO2"

## Description

La présente invention a pour objet un procédé selon le préambule de la revendication 1.

On sait que les matériaux polymères organiques, en particulier tels que les polycarbonates, exigent pour certaines utilisations pratiques à grande échelle, que soit assurée une amélioration significative de leurs propriétés mécaniques superficielles. Notamment, on sait ainsi que dans l'industrie automobile, les polycarbonates sont avantageusement utilisés pour remplacer le verre, par exemple dans la fabrication des optiques de phares, ces matériaux étant moins lourds et surtout mieux adaptés à la réalisation de formes complexes, allongées ou arrondies, des accessoires automobiles. Or, ces polycarbonates présentent une résistance en surface relativement médiocre, pouvant rapidement conduire à des détériorations notables et apparentes, largement préjudiciables.

Il s'avère donc indispensable d'assurer le dépôt sur le polycarbonate utilisé, d'un revêtement superficiel qui soit à la fois transparent et stable aux températures ambiantes, et également résistant à l'abrasion, aux chocs, à l'usure et aux autres agressions chimiques ou mécaniques dont il peut être l'objet, en particulier aux effets de l'humidité ou de la corrosion, aux actions des détergents etc...

Des dépôts en couches minces sur de tels substrats en matériau polymérique et en particulier à base de polycarbonates du genre précité, sont spécialement adaptés avec des composés à base de silicium, notamment d'oxydes, nitrures, carbures, ou alliages de ces composés tels que les oxynitrures. En effet, ces revêtements présentent des propriétés optiques et mécaniques qui répondent bien aux exigences des applications envisagées, en y joignant une résistance mécanique appréciable. Toutefois, la difficulté réside essentiellement dans l'obtention, lors de l'application du dépôt formant le revêtement sur le substrat, d'une adhérence convenable avec ce dernier, ce dépôt devant en outre être stable en présence des chocs thermiques éventuellement importants pouvant survenir dans les conditions d'environnement ambiant, le revêtement devant en outre être continu et non poreux. En effet, en raison de la faible stabilité thermique du substrat polymérique organique, le dépôt du revêtement doit, en règle générale, être réalisé à basse température, inférieure à 150°C pour les polycarbonates, au-delà de laquelle la surface du substrat se dégrade par transition vitreuse du polymère le constituant. Dans ces conditions, les techniques classiques de dépôts minces sur un support, notamment par action d'un flux de gaz ionisé ou plasma d'un composé inorganique et amorphe approprié, qui exigent des températures largement supérieures à 200° C, sont inadaptées. Il en va de même des procédés également connus, qui consistent à réaliser le revêtement au moyen d'une résine liquide de type silicone, déposée par trempage du substrat dans un bain, puis à polymériser le dépôt in situ à chaud, indépendamment du fait que le revêtement ainsi obtenu n'a pas les propriétés mécaniques et optiques de celui formé à partir de composés de silicium.

Dans la demande de brevet FR-A-2 614 317, on a déjà envisagé un procédé de protection d'un substrat polymérique au moyen d'un revêtement à base de composes notamment du type oxynitrures de silicium et plus généralement de composes de silicium et d'oxygène, et/ou d'azote et/ou d'hydrogène, qui consiste à exposer la surface du substrat aux précurseurs gazeux de ces éléments en présence d'un plasma d'un gaz auxiliaire mais à une température inférieure à celle de la transition vitreuse du substrat, ceci dans un réacteur où la pression est très faible (66,5 à 1,33·10³ Pa [0,5 à 10 torr]) et dans lequel les gaz contenant les éléments concernés sont capables de les libérer au sein du plasma de telle sorte qu'ils se recombinent ensuite entre eux directement sur le substrat pour former le dépôt inorganique souhaitè. Ainsi, on a plus spécialement préconisé dans cette demande, pour constituer les prècurseurs du silicium, l'emploi de monosilane (SiH4) ou de polysilanes (SinH2n+2), ou encore des halogenosilanes de formule (SiXnH4-n), les précurseurs de l'oxygène et/ou de l'azote étant pour leur part choisis parmi O2, N2O, N2 ou NH3.

Or, pour mettre en oeuvre un tel procédé, il convient de disposer de moyens notables, en particulier pour réaliser le plasma et confiner celui-ci ainsi que pour réguler les débits des différents flux gazeux nécessaires.

Il est connu de US - A - 4 615 294 un procédé d'un dépôt d'un revêtement protecteur inorganique SiN_{X}O_{Y} sur un substrat organique, polycarbonate, ce revêtement étant constitué d'un composé par décomposition photosensibilisée à partir d'un mélange de silane (SiH₄) et oxyde d'azote (N₂O) à réaliser par excitation photonique par une lampe d' éclairement à vapeur de mercure avec une longueur d'onde primaire de 235,7 nm (2357 Angströms) d'une impureté (mercure Hg) préalablement introduite dans le milieu en faisant barboter le milieu gazeux dans un bain de mercure liquide, propre à réaliser un transfert indirect d'énergie aux molécules de celui-ci, de manière à permettre la décomposition puis le dépôt de ces élément sur le substrat (voir colonne 12, lignes 6-56).

La présente invention concerne un procédé différent qui, sans avoir notamment recours à un plasma, permet de manière simple, efficace et peu coûteuse, l'obtention d'un dépôt mince, parfaitement adhérent, tout en présentant les qualités mécaniques, optiques et de résistance aux agressions chimiques qui sont indispensables pour les usages envisagés. L'invention vise également à réaliser, pour le dépôt mince adhérent au substrat, des couches de compositions variables et de faible épaisseur qui évitent des contraintes préjudiciables à l'interface entre le dépôt et le substrat.

A cet effet, le procédé considéré selon le préambule de la revendication 1 se caractérise en ce que le substrat est préalablement refroidi à une température inférieure à 0°C pour augmenter le taux de décomposition desdits composés ou de leurs alliages sur le substrat.

Selon le procédé de l'invention, la décomposition en phase gazeuse des composés incorporant les précurseurs des éléments entrant dans la composition du revêtement protecteur, notamment, pour ce qui concerne le silicium, des mélanges de silanes, polysilanes, halogenosilanes ou organosilanes, tels que méthylsilanes Sin(CH3)mH(2N+2-m) et de gaz apportant le second élément du dépôt, tel que O2, NO2, N2O, NH3, N2H4, SiH3NH2, des alcanes (CnH2n+2), des alkènes (CnH2n) ou de l'acétylène (C2H2), en vue de la formation de dépôts protecteurs de formulation SiOx, SiNy, SiCz ou leurs alliages Si(O,N,C), s'effectue en chargeant le milieu gazeux avec une impureté présentant une section efficace d'absorption de la lumière optimisée, réalisant le transfert d'énergie nécessaire à cette décomposition et autorisant la recombinaison subséquente des éléments du revêtement sur le substrat.

L'impureté mécanique introduite dans le milieu gazeux dépend du rayonnement photonique de la lampe. Ainsi, des impuretés métalliques telles que Hg, Cd... en combinaison avec des lampes à vapeur métallique du même élément pour bénéficier des raies spectrales d'absorption résonante peuvent être utilisées.

De préférence mais de façon non exclusive, l'impureté est du mercure Hg. Par ailleurs, on charge avantageusement le milieu gazeux avec le mercure par passage dans une réserve de ce métal liquide, maintenu à une température comprise entre 40 et 60°C. La concentration des atomes de mercure dans le milieu étant très faible et comprise entre 10¹² et 10¹³ atomes par centimètre cube, cette concentration est suffisante pour réaliser le transfert d'énergie provenant de la décomposition du milieu gazeux, tout en limitant la contamination du revêtement par l'impureté à une valeur très réduite, inférieure à 10 ppm.

Selon une autre caractéristique du procédé considéré, on introduit le milieu gazeux chargé de l'impureté notamment de mercure, dans un réacteur, à une pression comprise entre 13,3 et 13,3·10³ Pa [0,1 et 100 torr], de préférence entre 133 et 1333 Pa [1 et 10 torr], avec un débit compris entre 10 et 200 cc/sec, puis on soumet le mélange ainsi traité à un rayonnement photonique, notamment issu d'une lampe à vapeur de même élément que l'impureté introduite dans le milieu gazeux, traversant une fenêtre en quartz pour pénétrer dans le réacteur.

Selon l'invention, les molécules sont décomposées par le rayonnement, après absorption par le substrat, celui-ci étant de préférence refroidi et maintenu à une température négative déterminée, pouvant aller jusqu'à - 70°C. Dans tous les cas cependant, la pression du mélange gazeux dans le réacteur, la géométrie de celui-ci, la distance entre la lampe et le substrat, sont optimisées pour chaque type de mélange, en adoptant à chaque fois des paramètres réactionnels exactement déterminés.

Dans les conditions opératoires ainsi déterminées, les molécules des précurseurs du dépôt du revêtement protecteur (SiH4, O2, NH2, CH4...) sont alors décomposées par transfert d'énergie non radiatif des atomes photoexcités de l'impureté métallique introduite dans le milieu gazeux, en libérant les molécules de Si, O, N ou H, qui se recombinent ensuite sur le substrat, en formant le revêtement souhaité.

Les caractéristiques de dureté, de transparence et de résistance à l'abrasion et aux chocs du dépôt obtenu sont particulièrement améliorées vis-à-vis des revètements classiques, généralement peu adhérents et qui présentent une instabilité thermique particulièrement sensible, en raison notamment des différences des coefficients de dilatation linéaires entre le revétement et le substrat. En particulier, la dureté du revêtement obtenu est très notablement supérieure à celle du substrat; ainsi pour un polycarbonate de dureté Knoop égale à 32, celle du revêtement est comparable à celle du verre, en étant comprise entre 430 et 820. Le dépôt présente de plus des propriétés appréciables en ce qui concerne sa mouillabilité à l'eau et son pouvoir antistatique et comporte enfin des propriétés optiques avantageuses, en particulier une faculté de transmission élevée et une faible diffusion de la lumière.

Selon une autre caractéristique du procédé considéré, on peut encore améliorer les propriétés d'adhésion du revêtement avec un dépôt progressivement ou graduellement enrichi en azote, en nitrure ou en carbone.

Pour réaliser en outre une meilleure adhérence avec le substrat, l'expérience montre que l'on a intérêt à éviter les contraintes se produisant à l'interface entre le substrat et le dépôt protecteur réalisé sur celui-ci. Dans ce but et conformément à une autre caractéristique de l'invention, on peut procéder à la réalisation du revêtement avec un gradient de concentration variable selon une direction perpendiculaire à la surface du substrat de telle sorte que l'enrichissement en oxygène, en azote ou en carbone soit plus élevé vers l'extérieur qu'à l'interface avec le substrat.

Selon encore une autre caractéristique de l'invention, on peut augmenter la vitesse de dépôt du revêtement, en portant le substrat à une température inférieure à 0° C et pouvant atteindre - 70° C, le nombre d'atomes adsorbés par la surface du substrat étant sensiblement augmenté, typiquement de deux ordres de grandeur, la vitesse de dépôt étant elle-même accrue dans la même proportion.

Quel que soit le mode de mise en oeuvre du procédé, la variation d'épaisseur du revêtement est faible, inférieure à 10 %, cette épaisseur étant en moyenne égale ou légèrement supérieure à un micron. Si la surface du substrat est notable, en particulier supérieure à 25 cm², on peut utilement mettre en jeu plusieurs lampes à vapeur de mercure voisines, disposées côte à côte ; en variante, on peut aussi prévoir de faire défiler le substrat sous une lampe unique, à intensité du rayonnement constante.

Dans un mode de mise en oeuvre préféré du procédé selon l'invention, le substrat est du type polycarbonate, polymethylmethacrylate, polystyrène, polystyrène cristal ou acrylonitrile. Toutefois et de façon préférée, le substrat est en polycarbonate du type poly-(oxycarbonyloxyl-1,4-phénylène isopropylidéne-1,4-phénylène) ou est constitué par un copolymére à base de bisphénol A.

Les substrats transparents ainsi revêtus peuvent être utilisés, pour constituer des glaces de phares, des visières de casque de moto, des carénages, des vitres fixes de véhicules et hublots d'avion, des optiques d'éclairage urbain et domestique, des vitrages de sécurité, des écrans et protections pour appareils et tableaux indicateurs, des serres, vérandas et toitures en matière plastique, des disques ordinaires ou compacts et des verres de montres ou de lunettes, à titre d'exemples non limitatifs. L'invention peut cependant s'appliquer également à la protection de matériaux non transparents, dans de multiples applications industrielles ou grand public.

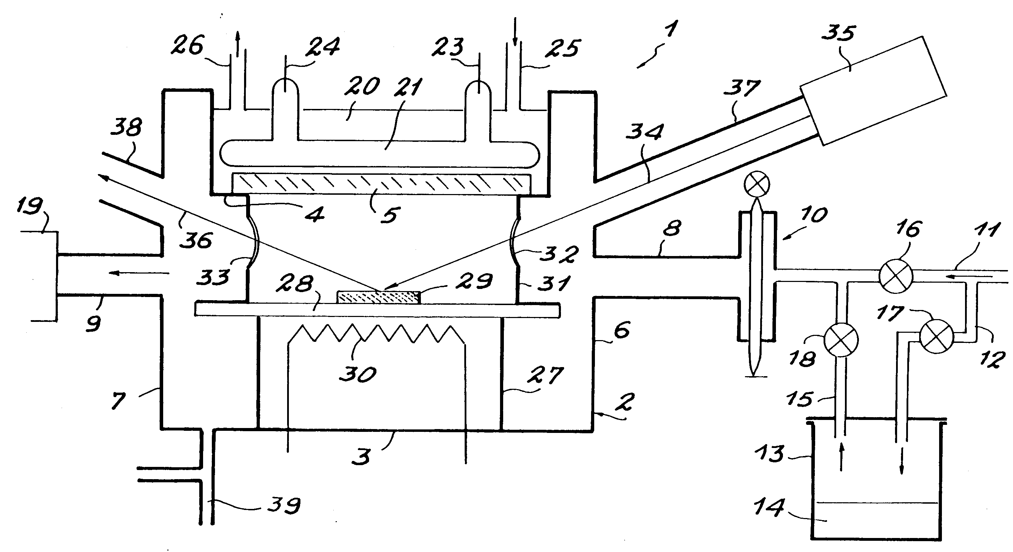

D'autres caractéristiques du procédé de l'invention, apparaîtront encore à travers la description qui suit d'un exemple de réalisation, donné à titre indicatif et non limitatif, en référence à la figure unique du dessin annexé qui représente, en coupe longitudinale, un schéma de principe d'un réacteur de mise en oeuvre du procédé selon l'invention.

Sur ce schéma le réacteur considéré est désigné dans son ensemble sous la référence 1. Il se compose principalement d'une enceinte close 2 comportant une paroi de fond 3 et une paroi supérieure ou plafond 4, dans une ouverture de laquelle est montée une fenêtre transparente 5, de préférence en quartz. L'enceinte 2 comporte dans ces parois latérales respectivement 6 et 7, des conduits 8 et 9, communiquant avec l'intérieur de l'enceinte et réservés, pour le conduit 8 à l'admission dans celle-ci du milieu gazeux contenant les précurseurs du revètement à réaliser et pour le conduit 9, à l'évacuation des résidus obtenus après décomposition de ce milieu.

Le conduit d'admission 8 comporte à l'entrée dans l'enceinte un dispositif de mesure 10 de la composition du milieu gazeux, celui-ci étant délivré à partir d'une source extérieure non représentée, par une canalisation 11 sur laquelle est connectée une dérivation 12 de telle sorte qu'une fraction au moins du débit de ce milieu gazeux traverse un barboteur 13, contenant un milieu liquide et en particulier constitué d'une impureté à introduire dans ce milieu. Le barboteur 13 contient ainsi un volume donné 14 d'un métal liquide, notamment du mercure, la température à l'intérieur du bain étant de préférence maintenue comprise entre 40 et 60°C.

La fraction ainsi chargée avec l'impureté est renvoyée par une canalisation de retour 15 vers la canalisation 11 et, de la, vers le conduit d'admission 8. Des vannes, respectivement 16, 17 et 18, sont montées sur les canalisations 11, 12 et 15 pour ajuster les débits relatifs du milieu gazeux et de la fraction de celui-ci traversant le barboteur 13. A l'opposé, le conduit d'évacuation 9 comporte une pompe d'aspiration 19, créant la dépression nécessaire à la circulation du milieu gazeux à l'intérieur de l'enceinte. Avantageusement, la pression à l'intérieur du réacteur est maintenue comprise entre 13,3 et 1,33·10³ Pa [0,1 et 10 torr], le débit du milieu gazeux étant lui-même limité entre 10 et 200 cc/sec, selon la nature des composants de ce milieu gazeux et par suite des éléments constituant le revêtement à déposer.

L'enceinte 2 comporte par ailleurs, montée au dessus de la fenêtre de quartz 5, à l'intérieur d'une cavité 20, une lampe 21 à vapeur de mercure, apte à fournir dans l'enceinte à travers la fenêtre un rayonnement lumineux d'énergie déterminée, avec une longueur d'onde également exactement définie, soit compris entre 185 et 254 nm pour le mercure. La lampe 21 est réunie par des connections électriques 23 et 24 à une source de tension appropriée permettant de créer dans la lampe la décharge lumineuse nécessaire à la production du rayonnement souhaité. En outre, la cavité 20 est réunie par des conduits 25 et 26 à un dispositif non représenté, permettant de faire circuler en permanence un débit d'un fluide de refroidissment, notamment de l'air, autour de la lampe.

A l'intérieur de l'enceinte 2 est disposé un élément d'appui 27 pour une platine de support 28, sur laquelle repose le substrat 29 sur lequel doit être réalisé le revêtement souhaité, ce substrat étant de préférence réalisé en un matériau polymérique organique et plus particulièrement encore, en polycarbonate. Sous la platine 28 est avantageusement montée un cryostat réglables, généralement désigné sous la référence 30, permettant d'ajuster la température du substrat préalablement au dépôt sur celui-ci du revêtement.

Le substrat est entouré par une cloison 31 formant écran, pour limiter les turbulences à l'admission et à l'évacuation du milieu gazeux pénétrant et sortant de l'enceinte par les conduits 8 et 9, l'écran 31 comportant des ouvertures 32 et 33, à la fois pour le passage du milieu gazeux au droit du substrat sous la fenêtre 5, mais également pour permettre d'effectuer en continu la mesure de l'épaisseur du dépôt réalisé sur le substrat, par exemple au moyen du rayonnement incident 34, issu d'un appareil de mesure 35 du genre réflectomètre ou ellipsomètre, réuni à l'enceinte 2 par une manchette de liaison 37, le rayonnement réfléchi 36 étant renvoyé par une seconde manchette 38 vers un détecteur (non représenté). Une prise 39 permet un prélèvement éventuel dans le milieu gazeux, pour analyse par exemple au moyen d'un spectrographe de masse.

La mise en oeuvre du procédé selon l'invention s'effectue à l'intérieur de l'enceinte du réacteur brièvement décrit ci-dessus, selon le processus déjà indiqué, en réalisant la décomposition en phase gazeuse à basse température du milieu gazeux dans lequel a préalablement été incoporée une impureté, ici du mercure, par apport d'énergie photonique en provenance de la lampe d'éclairement associée à l'enceinte. Cette décomposition des molécules gazeuses, résultant de l'excitation des atomes de l'impureté ainsi introduite qui présente une section efficace d'absorption optimisée du rayonnement délivré, permet aux précurseurs du dépôt, en particulier au silicium, à l'oxygène, au carbone ou à l'azote de se recombiner sur la surface du substrat, en formant alors directement sur celui-ci le dépôt recherché.

Divers exemples de mise en oeuvre sont donnes dans le tableau ci-après, à titre également non limitatifs. Le processus expérimental est dans tous les cas identique, et correspond aux opérations suivantes :
- l'échantillon est placé sur le porte substrat ;
- l'enceinte du réacteur est fermée et l'air qu'elle contient est soutiré pour atteindre un vide secondaire, avec une pression résiduelle de 1,33·10⁻⁴ à 1,33·10⁻⁵ Pa [10⁻⁶ à 10⁻⁷ torr];
- le refroidissement du porte substrat est amorcé jusqu'à atteindre la température d'équilibre souhaitée ;
- le réservoir d'impuretés métalliques, en l'espèce du Hg, est porté à une température comprise entre 40 et 60° C ;
- le système de pompage secondaire est isolé après introduction des gaz réactifs dans l'enceinte du réacteur, pour éviter une remontée d'huile du système de pompage ;
- les débits et la pression totale des gaz sont stabilisés aux valeurs désirées, le réglage de la pression s'effectuant au moyen d'une vanne de laminage ou d'un diaphragme située entre la pompe et l'enceinte ;
- la lampe à vapeur de mercure est mise sous tension et allumée jusqu'à stabilisation de sa température de travail et du flux lumineux qu'elle délivre. Pendant cette phase préliminaire, un écran amovible isole la lampe du hublot de quartz du réacteur ;
- la formation du dépôt commence une fois l'écran retiré, lorsque le milieu gazeux est soumis à l'irradiation de la lampe :
- la croissance du dépôt est interrompue en éteignant la lampe et en stoppant le débit des gaz.

Dans tous les cas indiqués ci-après, on utilise une lampe à vapeur de mercure basse pression, délivrant un rayonnement entre 10 et 20 mw/cm2 à 254 nm.

| | Dépôt formé | Gas utilisés | Ratio des gaz | Vitesse de dépôt |
|---|---|---|---|---|
| Exemple 1 | SiNx | Si2H6:NH3 N2 | 1:50:50 | 4nm/mn |
| Exemple 2 | SiO2 | SiH4:N20 | 1:50-200 | 20nm/mn |
| Exemple 3 | SiNx | SiH4:NH3 | 2:1-150 | 17nm/mn |
| Exemple 4 | SiCx | SiH4:C2H2 ou Si2H6 | 50:50 | 6nm/mn |
| Exemple 5 | SiCx | Si(CH3)2H2 | 100 | 2nm/mn |

Bien entendu et comme il résulte déjà de ce qui précède, il va de soi que l'invention ne se limite pas à ces exemples mais en embrasse au contraire toutes les variantes entrant dans le cadre des revendications ci-annexées.

## Revendications

1. Procédé pour la réalisation d'un dépôt d'un revêtement protecteur inorganique et amorphe sur un substrat polymérique organique, ce revêtement étant constitué de composés sous forme d'oxyde, nitrure, carbure, ou alliages de ces composés, par décomposition photosensibilisée en phase gazeuse d'un milieu gazeux incluant les précurseurs des éléments constituant le dépôt du revêtement protecteur inorganique amorphe à réaliser par excitation photonique d'une impureté préalablement introduite dans le milieu, propre à réaliser un transfert indirect d'énergie aux molécules de celui-ci, de manière à permettre la décomposition puis le dépôt de ces éléments sur le substrat, caractérisé en ce que le substrat est préalablement refroidi à une température inférieure à 0°C pour augmenter le taux de décomposition desdits composés ou de leurs alliages sur le substrat.

2. Procédé selon la revendication 1 caractérisé, en ce que le milieu gazeux est constitué à partir d'un mélange de silanes, polysilanes, halogénosilanes, ou organosilanes tels que les méthylsilanes Si(CH3)mH(2n+2-m) et de gaz tels que O2, NO2, N2O, NH3, N2H4, SiH3NH2, des alcanes (CnH2n+2), des alkènes (CnH2n) ou de l'acétylène (C2H2), en vue de la formation du dépôt protecteur de formulation SiOx, SiNy, SiCz ou de leurs alliages Si(O,N,C).

3. Procédé selon l'une des revendications 1 ou 2, caractérisé en ce que l'impureté introduite dans le milieu gazeux est du mercure Hg.

4. Procédé selon la revendication 3, caractérisé en ce que on fait barboter le milieu gazeux dans un bain de métal liquide, notamment maintenu à une température comprise entre 40 et 60°C.

5. Procédé selon l'une quelconque des revendications 1 à 4, caractérisé en ce que l'on introduit le milieu gazeux chargé de l'impureté dans un réacteur à une pression comprise entre 13,3 Pa et 13,3 kPa (0,1 et 100 torr) avec un débit compris entre 10 et 200 cc/sec, puis on soumet le mélange à un rayonnement photonique issu d'au moins une lampe d'éclairement.

6. Procédé selon l'une quelconque des revendications 1 à 5, caractérisé en ce que l'on introduit le milieu gazeux chargé de l'impureté dans un réacteur à une pression comprise entre 133,3 Pa et 1,33 kPa (1 et 10 torr).

7. Procédé selon la revendication 5 et 6 caractérisé en ce que on utilise une lampe d'éclairement à vapeur de mercure.

8. Procédé selon l'une quelconque des revendications 1 à 7, caractérisé en ce que on améliore les propriétés d'adhésion du dépôt sur le substrat en enrichissant le milieu gazeux en azote ou en carbone, ou encore en réalisant dans le revêtement un gradient de concentration variable selon une direction perpendiculaire à la surface du substrat de telle sorte que l'enrichissement en molécules d'oxygène ou d'azote soit plus élevé vers l'extérieur qu'à l'interface avec le substrat.

9. Procédé selon l'une des revendications 1 à 8, caractérisé en ce que le substrat est préalablement refroidi à une température comprise entre 0°C et - 70°C.

## Claims

1. Method for effecting a deposition of an inorganic, amorphous protective coating on an organic polymer substrate, this coating consisting of compounds in the form of oxides, nitrides, carbides or alloys of these compounds, by photosensitised decomposition in the gaseous phase of a gaseous medium including the precursors of the elements making up the amorphous inorganic protective coating to be deposited by photon excitation of an impurity previously introduced into the medium, suitable for transferring energy indirectly to the molecules of the latter, so as to enable these elements to be decomposed and then deposited on the substrate, characterised in that the substrate is previously cooled to a temperature below 0°C in order to increase the rate of decomposition of the said compounds or their alloys on the substrate.

2. Method according to Claim 1, characterised in that the gaseous medium is formed from a mixture of silanes, polysilanes, halogenosilanes, or organosilanes such as the methylsilanes Si(CH₃)ₘH₍₂ₙ₊₂₋ₘ₎ and gases such as O₂, NO₂, N₂O, NH₃, N₂H₄, SiH₃NH₂, alcanes (CₙH₂ₙ₊₂), alkenes (CₙH₂ₙ) or acetylene (C₂H₂), with a view to forming a protective deposit having the formula SiOₓ, SiN_{y}, SiC_{z} or their alloys Si(O,N,C).

3. Method according to either of Claims 1 or 2, characterised in that the impurity introduced into the gaseous medium is mercury Hg.

4. Method according to Claim 3, characterised in that the gaseous medium is bubbled through a bath of liquid metal, maintained notably at a temperature between 40° and 60°C.

5. Method according to any one of Claims 1 to 4, characterised in that the gaseous medium containing the impurity is introduced into a reactor at a pressure between 13.3 Pa and 13.3 kPa (0.1 and 100 torr) at a flow rate between 10 and 200 cc/sec, and then the mixture is subjected to photon radiation from at least one illuminating lamp.

6. Method according to any one of Claims 1 to 5, characterised in that the gaseous medium containing the impurity is introduced into a reactor at a pressure between 133.3 Pa and 1.33 kPa (1 and 10 torr).

7. Method according to Claims 5 and 6, characterised in that a mercury-vapour illuminating lamp is used.

8. Method according to any one of Claims 1 to 7, characterised in that the properties of adhesion of the deposit on the substrate are improved by enriching the gaseous medium with nitrogen or carbon, or by producing in the coating a concentration gradient variable in a direction perpendicular to the surface of the substrate so that the enrichment in oxygen or nitrogen molecules is greater towards the outside than at the interface with the substrate.

9. Method according to one of Claims 1 to 8, characterised in that the substrate is previously cooled to a temperature between 0°C and -70°C.

## Patentansprüche

1. Verfahren zum Auftragen einer amorphen, anorganischen Schutzschicht auf ein polymeres organisches Substrat durch photosensibilisierte Zersetzung, wobei die Schutzschicht aus Verbindungen in Gestalt eines Oxids, eines Nitrids, eines Karbids oder von Gemengen dieser Verbindungen besteht, wobei die photosensibilisierte Zersetzung in der Gasphase aus einem gasförmigen Medium die Vorläufer der Elemente enthält, welche die aufzutragende amorphe anorganische Schutzschicht bilden, die durch Photonenerregung einer Beimengung aufgetragen werden soll, die vorausgehend in das Medium eingeführt worden ist, um eine indirekte Energieübertragung auf die Moleküle der Schicht derart zu bewirken, daß diese Elemente zersetzt und dann auf dem Substrat aufgetragen werden, dadurch gekennzeichnet, daß das Substrat vorausgehend auf eine Temperatur unterhalb von 0°C abgekühlt wird, um das Zersetzungsmaß der Verbindungen oder ihrer Gemenge auf dem Substrat zu erhöhen.

2. Verfahren nach Anspruch 1, dadurch gekennzeichnet, daß das gasförmige Medium aus einem Gemisch von Silanen, Polysilanen, Halogensilanen oder Organosilanen gebildet wird, wie beispielsweise Methylsilanen Si(CH₃)mH₍₂ₙ₊₂₋ₘ₎ und Gasen wie O₂, NO₂, N₂O, NH₃, N₂H₄, SiH₃NH₂, Alkanen (CₙH₂ₙ₊₂), Alkenen (CₙH₂ₙ) oder Acetylen (C₂H₂), um eine Schutzschicht mit der Zusammensetzung SiOₓ, SiN_{y}, SiC_{z} oder ihren Gemengen Si(O,N,C) zu bilden.

3. Verfahren nach Anspruch 1 oder 2, dadurch gekennzeichnet, daß die in das gasförmige Medium eingeführte Beimengung Quecksilber (Hg) ist.

4. Verfahren nach Anspruch 3, dadurch gekennzeichnet, daß das gasförmige Medium durch ein Bad eines flüssigen Metalls hindurchgeleitet wird, das insbesondere auf einer Temperatur zwischen 40 und 60°C gehalten ist.

5. Verfahren nach einem der Ansprüche 1 bis 4, dadurch gekennzeichnet, daß das mit der Beimengung beladene gasförmige Medium unter einem Druck zwischen 13,3 Pa und 13,3 kPa (0,1 und 100 Torr) mit einem Durchfluß zwischen 10 und 200 cm³/sek in einen Reaktor eingeleitet wird, wobei das Gemisch daraufhin einer Photonenbestrahlung unterworfen wird, die von zumindest einer Leuchte abgegeben wird.

6. Verfahren nach einem der Ansprüche 1 bis 5, dadurch gekennzeichnet, daß das mit der Beimengung beladene gasförmige Medium in einem Reaktor unter einem Druck zwischen 133,3 Pa und 1,33 kPa (1 und 10 Torr) eingeleitet wird.

7. Verfahren nach Anspruch 5 und 6, dadurch gekennzeichnet, daß eine Quecksilberdampflampe verwendet wird.

8. Verfahren nach einem der Ansprüche 1 bis 7, dadurch gekennzeichnet, daß die Adhäsionseigenschaften der auf das Substrat aufgetragenen Schicht durch Anreichern des gasförmigen Mediums mit Stickstoff oder Kohlenstoff oder durch Ausbilden eines Konzentrationsgradienten in der Schicht verbessert werden, der in einer Richtung lotrecht zur Oberfläche des Substrats derart variiert, daß die Anreicherung der Sauerstoff- oder Stickstoffmoleküle nach außen hin einen höheren Wert hat als an der Grenzfläche zu dem Substrat.

9. Verfahren nach einem der Ansprüche 1 bis 8, dadurch gekennzeichnet, daß das Substrat vorausgehend auf eine Temperatur zwischen 0° C und -70° C abgekühlt wird.
